Europäisches Patentamt

European Patent Office

Office européen des brevets

(19)

(11) Veröffentlichungsnummer: **0 216 954**
**B1**

(12) **EUROPÄISCHE PATENTSCHRIFT**

(45) Veröffentlichungstag der Patentschrift: **18.07.90**

(21) Anmeldenummer: **85112967.6**

(22) Anmeldetag: **12.10.85**

(51) Int. Cl.⁵: **H 01 L 21/225, C 23 C 14/02**

(54) **Verfahren zur Aluminium-Dotierung einer Halbleiteranordnung.**

(30) Priorität: **10.06.85 DE 3520699**

(43) Veröffentlichungstag der Anmeldung:
**08.04.87 Patentblatt 87/15**

(45) Bekanntmachung des Hinweises auf die
Patenterteilung:
**18.07.90 Patentblatt 90/29**

(84) Benannte Vertragsstaaten:
**DE FR GB SE**

(56) Entgegenhaltungen:
EP-A-0 054 317
DE-A-1 419 289
DE-A-2 812 658
US-A-4 154 632
US-A-4 199 386

5th INTERNATIONAL COLLOQUIUM ON
PLASMAS AND SPUTTERING, Antibes, FR,
10.-14. Juni 1985, Seiten 89-92; J. VOBORIL et
al.: "Effects of in-situ-Ar-ion milling on the
diffusion homogeneity of al into Si from thin,
sputtered films"

(73) Patentinhaber: **BBC Brown Boveri AG**
**Haselstrasse**
**CH-5401 Baden (CH)**

(72) Erfinder: **Keser, Helmut**
**Sonnmatt**
**CH-5242 Birr (CH)**
Erfinder: **Voboril, Jan, Dipl.-Ing. Phys.**
**Landschreiberstrasse 2**
**CH-5415 Nussbaumen (CH)**

(56) References cited:
JOURNAL OF VACUUM SCIENCE AND
TECHNOLOGY, Band 16, Nr. 2, März/April 1979,
Seiten 369-376, American Vacuum Society, New
York, US; P.S. McLEOD et al.: "Effects of sputter
etching and process techniques on the
properties of sputtered aluminum films"

SOLID-STATE TECHNOLOGY, Band 22, Nr. 6,
Juni 1979, Seiten 61-68, Port Washington, New
York, US; W.H. CLASS: "Deposition and
characterization of magnetron sputtered
aluminum and aluminum alloy films"

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

**EP 0 216 954 B1**

(56) References cited:
JOURNAL OF PHYSICS E, SCIENTIFIC
INSTRUMENTS, Band 12, Nr. 3, März 1979,
Seiten 159-167, Institute of Physics, London,
GB; J.L. VOSSEN: "The preparation of
substrates for film deposition using glow
discharge techniques"

# EP 0 216 954 B1

**Beschreibung**

Bei der Erfindung wird ausgegangen von einem Verfahren zum Herstellen einer Halbleiteranordnung nach dem Oberbegriff der Patentanspruchs 1. Die Erfindung betrifft auch eine Halbleiteranordnung.

Mit dem Oberbegriff nimmt die Erfindung auf einen Stand der Technik von Verfahren zum Herstellen einer Halbleiteranordnung Bezug, wie er in der DE—AS—2 812 658 beschrieben ist. Dort wird auf eine Hauptfläche eines Einkristall-Siliziumhalbleitersubstrats Aluminium aus einem Aluminiumdraht mit einer Reinheit von 99,9995% als Aluminiumquelle in einer Stärke von weniger als 2 µm in einem gitterförmigen Muster abgeschieden. Der Aluminiumdraht wird durch einen Elektronenstrahl erhitzt und das Aluminium bei einem Druck im Bereich von 270 µPa bis 400 µPa auf dem auf 230°C—250°C erhitzten Siliziumsubstrat abgeschieden und nach üblicher Weise photolithographisch strukturiert. Das Si-Substrat wird in einer Atmosphäre aus einem nicht oxydierenden Gas, wie Stickstoff oder Argon, und 0,05—10 Vol-% Sauerstoff bis zur Ausbildung einer zusammenhängenden Oxidschicht auf der Aluminium- und Siliziumoberfläche erhitzt. Nachteilig dabei ist, dass durch den Elektronenstrahl auch die Umgebung des bestrahlten Aluminiumdrahtes auf eine hohe Temperatur ansteigt, was zu einer Verdampfung z.B. von Tiegelmaterial und damit zu einer unerwünschten Verunreinigung der Aluminiumaufdampfschicht führen kann.

Schwierigkeiten treten auf, wenn die mit Aluminium beschichtete Siliziumscheibe aufgeheizt wird, da die Al-Si-Schmelze wegen einer Zwischenschicht auf der Si-Oberfläche nicht gleichmässig verteilt ist, was sich als Bildung von kleinen Tröpfchen zeigt. Infolgedessen ist die Homogenität der Diffusion nicht gewährleistet.

Aluminium, das über eine grosse Diffusionskonstante in Silizium verfügt, ist einer der wichtigsten Dotierstoffe zur Herstellung von Leistungshalbleiterbauelementen wie Dioden und Thyristoren.

Für eine Randkonturierung, d.h. die Formgebung des Randes eines Halbleiterbauelementes, wie es für Hochspannungsbauelemente benötigt wird, ist es von Vorteil, wenn der sperrende pn-Uebergang, auf dem die ganze Spannung in Sperrichtung liegt, am Rand tiefer gezogen wird oder wenn ein sogenannter Schutzring ausgebildet werden kann. Für feldgesteuerte Thyristoren ist ein tiefer pn-Uebergang zu diffundieren, wofür eine tiefe selektive p-Diffusion notwendig ist. Im Hinblick auf die erforderliche Eindringtiefe dieser Diffusion kommt als Dotierstoff praktisch nur Aluminium in Frage, da Bor oder Gallium eine zu geringe Diffusionskonstante aufweisen. Die Diffusionskonstante von Aluminium ist etwa 10 mal so gross wie die von Bor. Gallium diffundiert zwar etwas schneller im Vergleich zu Bor, es ist aber nicht maskierbar. Das Problem einer selektiven Al-Diffusion ist bis jetzt nicht zufriedenstellend gelöst worden.

Aus der DE—A—14 19 289 ist bekannt, dass sich eine gut reproduzierbare Dotierung erzeugen lässt, wenn eine Elektrode, welche aus dem Dotierstoff besteht, in einer Gasentladung zerstäubt wird, sodass der Dotierstoff auf einen Halbleiterkörper aufgebracht und gleichzeitig eindiffundiert wird. Wenn ausserdem vor dem Aufbringen des Dotierstoffes der Halbleiterkörper kurzzeitig als Kathode geschaltet wird, so wird die Oberfläche des Halbleiterkörpers zusätzlich noch gereinigt und von Unebenheiten befreit. Auch bei diesem Verfahren ergeben sich jedoch Probleme, wenn es zur selektiven Diffusion von Aluminium eingesetzt werden soll.

Die Erfindung, wie sie im Patentanspruch 1 definiert ist, löst die Aufgabe, ein vereinfachtes Verfahren zum Herstellen einer Halbleiteranordnung anzugeben, mit dem es möglich ist, eine tiefe aluminiumdotierte Zone in einem Siliziumsubstrat mit grosser Selektivität einzustellen.

Ein Vorteil der Kathodenzerstäubung besteht darin, dass kontaminationsfreie Aluminiumschichten auf die Oberfläche der Siliziumscheibe aufgebracht werden können. Es lässt sich eine höhere Reinheit des Aluminiums auf dem Siliziumsubstrat erreichen und der Anteil an Verunreinigungen durch Fremdatome, insbesondere durch Schwermetallatome, verringern.

Ein Vorteil der Zerstäubung in einem Edelgas besteht darin, dass keine Reaktionsprodukte im Gasplasma entstehen können.

Die Edelgasbombardierung hat den Vorteil, dass die anschliessend aufgebrachte Aluminiumschicht auf der Unterlage gut haftet und mit dem Silizium gleichmässig verschmilzt, so dass keine Tröpfchenbildung des Aluminiums auf der Siliziumoberfläche auftritt.

Eine vorzugsweise aufgebrachte Diffusions-Schutzschicht verhindert das Eindiffundieren unerwünschter Fremdatome in das Silizium.

Ein Vorteil der Einhaltung der Temperaturbedingungen besteht darin, dass der gewünschte tiefe pn-Uebergang gut reproduzierbar eingestellt werden kann.

Das Unterätzen gemäss hat den Vorteil, dass ein mechanisches Entfernen der Reste der Aluminiumquellen durch Abschleifen und Polieren der oberen Hauptfläche der Siliziumscheibe entfällt und die glatte Oberfläche der nicht dotierten Bereiche erhalten bleibt.

Ein Vorteil beabstandeter Aluminiumquellen besteht darin, dass das Unterätzen für relativ grossflächige Dotierzonen verwendet werden kann.

Durch ein isotrop wirkendes Aetzmittel wird erreicht, dass die Aetztiefe relativ klein gehalten werden kann.

Ein maskiertes Aufbringen von Photolack hat den Vorteil, dass nur die Bereiche der Aluminiumquellen geätzt werden und die übrigen Bereiche in ihrem polierten Zustand erhalten bleiben.

Zum einschlägigen Stand der Technik wird zusätzlich auf die US—PS—4,199,386 verwiesen, aus der es bekannt ist, auf die Siliziumscheibe eine komplizierte Struktur aus mehreren Schichten aufzubringen, die dann strukturiert wird und als Diffusionsquelle dient.

Aus der EP—B1—0 054 317 ist es bekannt, mehrere Aluminiumquellen mit Abmessungen von ca. 6 µm×6 µm zur Erzeugung eines aluminiumdotierten Gebietes in einer n-leitenden Siliziumschicht zu verwenden. Die Aluminiumquellen haben einen gegenseitigen Abstand von etwa 4 µm und eine Dicke von $\geqq 0,5$ µm oder, nach einer vorangegangenen Korngrenzenätzung, eine Dicke von $\leqq 0,2$ µm. Vor der in einer oxydierenden Atmosphäre durchgeführten Diffusionsbehandlung (10 h bei 1200°C) erfolgt eine Aetzung von 30 s Dauer in einer Lösung von Wasserstofffluorid in Wasser, wobei Oxid von der Oberfläche der Teile entfernt wird. Es ist nicht angegeben, wie die nach der Diffusionsbehandlung verbleibenden Reste der Aluminiumquellen, insbesondere das darauf entstandene Aluminiumoxid, entfernt werden.

Die Erfindung wird nachstehend anhand von Ausführungsbeispielen erläutert. Es zeigen:

Fig. 1 eine Anordnung zur Aluminiumbeschichtung einer Siliziumscheibe,

Fig. 2 eine Siliziumscheibe gemäss Fig. 1, die mit Aluminium und Photolack beschichtet ist,

Fig. 3 eine Siliziumscheibe gemäss Fig. 2 nach dem Wegätzen des Aluminiums,

Fig. 4 eine Siliziumscheibe gemäss Fig. 3 nach dem Entfernen des Photolacks,

Fig. 5 eine Siliziumscheibe gemäss Fig. 4 mit aluminiumdotierten Zonen nach einer Diffusion in sauerstoffhaltiger Atmosphäre,

Fig. 6 ein Diffusionsprofil durch eine aluminiumdotierte Zone gemäss Fig. 5,

Fig. 7 eine Siliziumscheibe im Ausschnitt mit mehreren Aluminiumquellen zur Herstellung einer aluminiumdotierten Zone.

Fig. 8 eine Siliziumscheibe gemäss Fig. 7 nach der Diffusionsbehandlung mit einer aluminiumdotierten Zone,

Fig. 9 eine Siliziumscheibe gemäss Fig. 8 mit einer maskierten Photolackbeschichtung,

Fig. 10 eine Siliziumscheibe gemäss Fig. 9 während einer Silizium-Aetzbehandlung,

Fig. 11 eine Siliziumscheibe gemäss Fig. 10 nach der Silizium-Aetzbehandlung und nach der Entfernung des Photolacks,

Fig. 12 ein Diffusionsprofil durch eine aluminiumdotierte Zone gemäss Fig. 11,

Fig. 13 eine Anordnung von Aluminiumquellen auf einer ausschnittsweise dargestellten Siliziumscheibe für die Durchführung einer Trenndiffusion,

Fig. 14 eine ausschnittsweise dargestellte Siliziumscheibe mit einer flachen p+-Zone,

Fig. 15 eine Siliziumscheibe gemäss Fig. 14 mit mehreren Aluminiumquellen zur Herstellung einer örtlich tiefen p+-Zone,

Fig. 16 eine Siliziumscheibe gemäss Fig. 15 nach der Diffusionsbehandlung,

Fig. 17 eine Siliziumscheibe gemäss Fig. 16 während einer Silizium-Aetzbehandlung und

Fig. 18 eine Siliziumscheibe gemäss Fig. 17 nach der Silizium-Aetzbehandlung und nach der Entfernung des Photolacks.

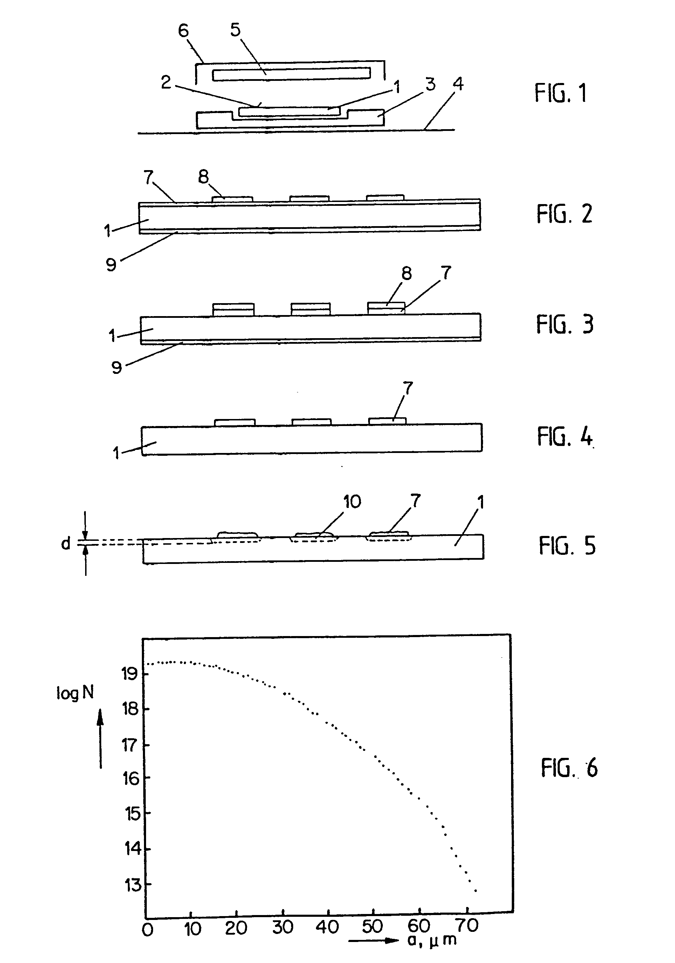

In Fig. 1 ist mit 1 eine Siliziumscheibe bzw. ein Siliziumsubstrat bezeichnet, dessen obere Hauptfläche 2 poliert ist und mit Aluminium beschichtet werden soll. Die Siliziumscheibe 1 vom n-leitenden Typ hat einen Durchmesser von 50,8 mm und einen spezifischen Widerstand im Bereich von 40 Ωcm—60 Ωcm. Sie liegt auf einer Unterlagscheibe 3 aus Silizium, so dass sie während der Aluminiumbeschichtung in einer im Handel erhältlichen Hochvakuum-Kathodenzerstäubungsanlage mit deren Drehteller 4 nicht in Kontakt kommt. 5 bezeichnet eine Aluminium-Prallplatte bzw. ein Al-Target, das als Kathode geschaltet ist und zerstäubt wird. Dieses Al-Target 5 wird durch eine Abschirmelektrode 6 abgeschirmt.

Im Plasma eines Edelgases, vorzugsweise in einem Argon-Plasma, wird durch Ionenbeschuss das Al-Target 5 zerstäubt und ein Aluminiumbelag bzw. eine Aluminiumschicht 7 vorgebbarer Dicke von z.B. 1 µm auf der Siliziumscheibe 1 niedergeschlagen, vgl. Fig. 2. Dabei ist von grosser Bedeutung, dass die Si-Oberfläche vor dem Zerstäuben etwa 10 min lang bei 20 µbar Argondruck mit Ar-Ionen bombardiert wird, was zum Abtrag der Siliziumschicht und der darauf befindlichen SiO$_2$-Haut (native oxide) führt. Damit wird der direkte Kontakt zwischen Al und Si ohne die störende Trennschicht gewährleistet, und diese aufgebrachte Al-Schicht schmilzt mit dem Silizium gleichmässig zusammen.

Würde die Aluminiumschicht 7 nur aufgestäubt werden, ohne vorherigen Abtrag durch Bombardierung der Hauptfläche 2 mit Ar-Ionen, so könnte es bei einer nachfolgenden Diffusion zu einer unerwünschten Tröpfchenbildung des Aluminiums auf der Hauptfläche 2 kommen, wobei kleine Bereiche der Hauptfläche 2 ohne Aluminiumschicht bleiben.

Das Zerstäuben erfolgt bei einem Argondruck von 8 µbar mit einer Ablagerungsgeschwindigkeit von 340 pm/s bis zu einer Schichtdicke von 1 µm. Es ist im Vergleich zum Aufdampfen ein relativ kalter Prozess, was zur Sauberkeit der aufgebrachten Substanz beiträgt, da kein Schiffchen oder Tiegel aufgeheizt wird, die eine Kontaminationsquelle darstellen. Eine Verschmutzung durch den Drehteller 4, auf de die Siliziumscheibe 1 in der Zerstäubungsanlage aufliegt, kann durch Unterlegen der ein bisschen grösseren Silizium-Unterlagscheibe 3 verhindert werden. Diese Unterlagscheibe 3 hat in der Mitte eine Vertiefung, in der die zu behandelnde Siliziumscheibe 1 liegt und nicht wegrutschen kann.

Nach dem Zerstäuben wird die Aluminiumschicht 7 auf übliche Weise photolithographisch maskiert und ein punktförmiger, handelsüblicher Photolackbelag 8 aufgebracht. Photolack ist z.B. unter der Bezeichnung AZ-1350 J-SF von der deutschen Firma Höchst erhältlich. Es ist zweckmässig, auch auf der

EP 0 216 954 B1

Rückseite der Siliziumscheibe 1 einen Photolackbelag 9 aufzubringen, um zu verhindern, dass die Siliziumscheibe bei einem späteren Manipulieren kontaminiert wird.

Nach dem Aufbringen der Photolackbeläge 8 und 9 wird das Aluminium in einem "ISOFORM"-Aluminium-Aetzmittel der M.I.T.-Halbleiter-Chemie-GmbH, Solingen, Deutschland, bei 55°C 30 s lang geätzt, so dass die in Fig. 3 gezeigte Struktur entsteht. Als Aluminium-Aetzmittel kann eine Mischung folgender Zusammensetzung verwendet werden:

| 75 ml | 85 %ige Phosphorsäure, $H_3PO_4$, |
|---|---|
| 10 ml | Wasser, $H_2O$, |
| 5 ml | 98 %ige Essigsäure, $CH_3COOH$, |
| 3 ml | 65 %ige—70 %ige Salpetersäure, $HNO_3$ und ggf. |
| 1 ml | Netzmittel (z.B. Triton). |

Anschliessend wird der nicht mehr benötigte Photolack mit Aceton und Isopropanol je 15 s im Ultraschallbad entfernt und die Siliziumscheibe 1 mit Wasser gespült und getrocknet, so dass die in Fig. 4 dargestellte Struktur entsteht.

Die Haftung des Aluminiums kann jetzt durch Anlassen bei 480°C—500°C 30 min lang im Vakuum noch verbessert werden; sie ist jedoch im Vergleich zu einer $Ar^+$-Bombardierung von untergeordneter Bedeutung, was Experimente bestätigten.

Das anschliessende Diffundieren des Aluminiumbelags 7 in die Siliziumscheibe 1 erfolgt 300 min lang bei einer Temperatur von 1250°C in einem Gasgemisch aus $N_2$ (1 l/min) und $O_2$ (20 ml/min), wobei die Aufheizgeschwindigkeit 3 K/min beträgt. Das Abkühlen erfolgt mit einer Abkühlgeschwindigkeit von 1 K/min.

Der Sauerstoff hat die Aufgabe, die Aluminiumdämpfe aus der Aluminiumschicht in Aluminiumoxid $Al_2O_3$ umzuwandeln.

$Al_2O_3$ ist als Diffusionsquelle unwirksam und kann auf unerwünschten Stellen keine p-Schicht erzeugen. Statt Stickstoff kann man auch Argon verwenden. Die Gebiete, in denen keine Diffusion stattfinden soll, können zusätzlich mit einer $SiO_2$-Schicht als Diffusionsbarriere gegen die anderen Dotierstoffe, die im Rohr oder bereits in der Siliziumscheibe vorhanden sind, versehen sein.

Nach der Diffusion können die Ueberreste von Al, $Al_2O_3$, Schmelze aus Al-Si und ggf. $SiO_2$ abgeätzt und abgeläppt werden. Der Abtrag beim Polieren ist dabei im Vergleich zum Abtrag durch die Al-Vorbelegung gering.

Falls eine niedrigere Randkonzentration gewünscht wird, kann jetzt eine sogenannte Eintreib-(drive-in)Diffusion angeschlossen werden.

Bei der Diffusion diffundieren Aluminiumatome bis zu einer Diffusionstiefe d in das Innere der Siliziumscheibe 1 und bilden dort in dem n-leitenden Silizium eine $p^+$-dotierte Zone 10, vgl. Fig. 5.

Das resultierende Diffusionsprofil unter einer Aluminiumschicht 7 ist in Fig. 6 dargestellt, in der auf der Abszisse die Eindringtiefe a der Aluminiumatome in µm und auf der Ordinate log N, N=Al-Konzentration=Anzahl Al-Atome/$cm^3$, aufgetragen sind. Mit zunehmender Eindringtiefe a ab der Hauptfläche 2 nimmt die Konzentration N ab. Auf den Gebieten ohne Aluminiumschicht 7 wurde keine p-Dotierung gefunden.

Für die Herstellung feldgesteuerter Thyristoren sind tief diffundierte p-Gebiete mit Eindringtiefen von $\geqq 50$ µm, vorzugsweise von 75 µm und Randkonzentrationen im Bereich von $10^{16}$ $cm^{-3}$—$10^{17}$ $cm^{-3}$ erforderlich. Die tief diffundierten p-Gebiete grenzen das Bauelement ab. Erst dadurch ist eine Randkonturierung des hochsperrenden pn-Uebergangs möglich. Die Oberfläche des Halbleiterbauelements muss, zumindest auf den nichtdotierten Gebieten, poliert sein, damit bei der Maskierung die Maske gut sitzt und die feine Struktur des Bauelementes realisierbar ist.

Der Herstellungsprozess umfasst folgende Schritte:

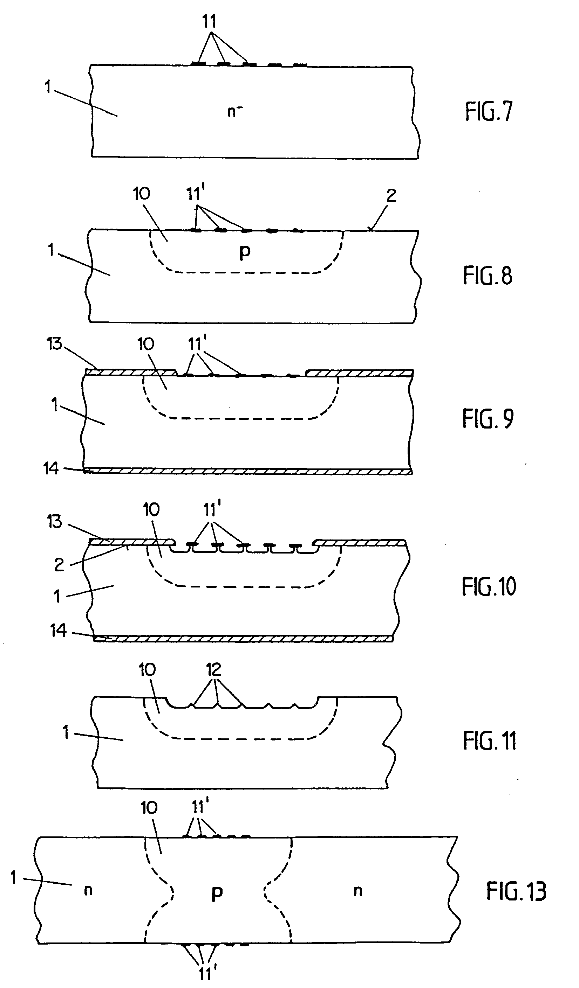

1. Aufbringen und Strukturieren einer Al-Schicht auf die Si-Oberfläche, wie in Verbindung mit den Fig. 1—4 beschrieben. Die Periode der Struktur ist dabei jedoch wesentlich kleiner im Vergleich mit der Eindringtiefe der folgenden Diffusion, vorzugsweise kleiner als 1/3 der Eindringtiefe. Auf eine aluminiumdotierte Zone 10 gemäss Fig. 8 kommen mehrere Aluminiumquellen 11 mit einer Periode von 25 µm, vgl. Fig. 7 Die Aluminiumquellen 11 können kreisförmigen, rechteckigen, streifenförmigen oder anderen Querschnitt aufweisen. Vorzugsweise wird ein quadratischer Querschnitt mit etwa 10 µm Kantenlänge verwendet.

2. Diffusion im Bereich von 1200°C—1300°C in einem Gasgemisch aus $N_2$ und bis zu 10 Vol-% $O_2$ solange (300 min), bis die gewünschte Eindringtiefe erreicht ist. Aufheizen mit 3 K/min, Abkühlen mit 1 K/min. Nach der Diffusion bleiben Reste 11' der Aluminiumquellen 11 übrig, vgl. Fig. 8, die an der oberen Hauptfläche 2 der Siliziumscheibe 1 um etwa 2 µm—3 µm herausragen und Aluminiumoxid $Al_2O_3$ an der Oberfläche aufweisen.

3. Aufbringen eines Photolackbelages 13 auf die nicht diffundierten Gebiete der Si-Oberfläche und eines ganzflächigen Photolackbelages 14 auf der Rückseite der Siliziumscheibe 1, vgl. Fig. 9. Dabei wird ein Photolack verwendet, der unter der Bezeichnung SC-450 von der USA-Firma Hunt Chem. Corporation erhältlich ist.

4. Unterätzen der Reste 11' der Aluminiumquelle 11. Die Reste 11', die in Form von Aluminiumoxiden und -nitriden auf der Siliziumoberfläche geblieben sind, sind nasschemisch nicht entfernbar. Zu deren Entfernung wird ein Siliziumätzmittel, vorzugsweise Schwefelhexafluorid $SF_6$ oder eine Aetzmischung aus

| 230 ml | Flussäure HF, |
| 470 ml | Salpetersäure $HNO_3$, |
| 200 ml | Essigsäure $CH_3COOH$, |
| 100 ml | Phosphorsäure $H_3PO_4$, |

bei einer Badtemperatur im Bereich von 2°C—4°C während etwa 2 min...3 min verwendet, die das Silizium ätzt. Dieses Silizium-Aetzmittel greift auf den nicht mit Photolack 13 bzw. 14 geschützten Flächen das Silizium durch die Oeffnungen in der Aluminiumrestschicht an. Bei dem isotrop wirkenden Aetzmittel kommt es zum Unterätzen der Struktur, wie in Fig. 10 dargestellt. Schliesslich werden die Reste 11' der Aluminiumquellen 11 abgetrennt und mit dem Aetzmittel weggespült. Unterhalb des Ortes der entfernten Aluminiumquellen 11 bleiben pyramiden- bzw. kegelförmige Erhöhungen 12 in der Oberfläche der aluminiumdotierten Zone 10, die dieser Zone ein geripptes Aussehen verleihen, vgl. Fig. 11.

5. Entfernen der Photolackschichten 13 und 14 in rauchender Salpetersäure $HNO_3$, vgl. Fig. 11.

Bei diesem Verfahren werden nur herkömmliche Schritte verwendet. Das Zusammenfliessen der Al-Si-Schmelze ist weitgehend unterbunden. Es dürfen ohne Gefahr dickere Al-Schichten verwendet werden, wobei sehr grosse Eindringtiefen bei der Diffusion erreichbar sind. An der undotierten Si-Oberfläche entstehen keine Verluste oder Beschädigungen. Da die Oberfläche auf den dotierten Gebieten versenkt ist, stellt sie keine Gefahr für eine Maske bei folgenden photolithographischen Prozessen dar. Beim Ausätzen der Al-Reste nach der Diffusion wird auch die Siliziumschicht entfernt, die beim Erstarren der Al-Si-Schmelze beim Abkühlen verspannt ist und als Quelle für Kristalldefekte bei den folgenden Hochtemperaturprozessen dienen könnte.

Im Vergleich mit einer kompakten, nicht strukturierten Al-Schicht ist die beschriebene Struktur eine schwächere Diffusionsquelle, da es während der Diffusion auch zur Ausdiffusion des Aluminiums durch die Oeffnungen in der Al-Schicht kommt. Das kann aber zum Einstellen des gewünschten Verlaufs des Dotierungsprofils genützt werden, indem man das Verhältnis der Al-beschichteten und der nichtbeschichteten Fläche ändert.

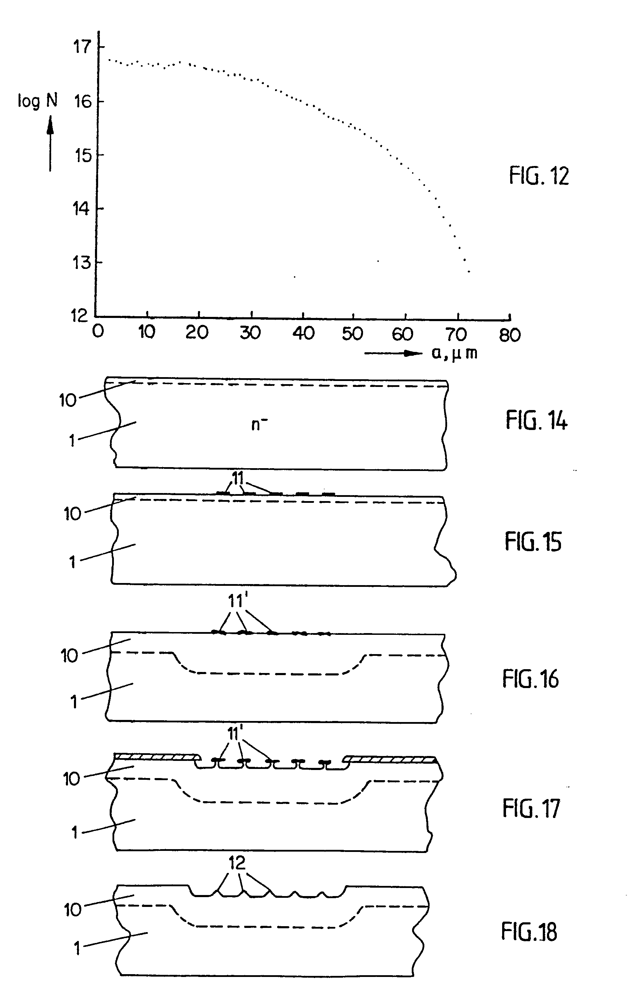

Fig. 12 zeigt ein der Fig. 6 entsprechendes Al-Konzentrationsprofil durch eine p-dotierte Zone 10 in Fig. 11, aus der ersichtlich ist, dass in einer Eindringtiefe a von etwa 73 μm von der Oberfläche noch eine Al-Konzentration N von $10^{12}$ Al-Atomen/$cm^3$ vorhanden ist und an der Oberfläche eine solche von ca. $8 \cdot 10^{16}$ Al-Atome/$cm^3$.

Fig. 13 zeigt die Anwendung des in Verbindung mit den Fig. 7—11 beschriebenen Verfahrens für die Trenndiffusion, bei der das Aluminium von den Aluminiumquellen 11 von beiden Hauptflächen der Siliziumscheibe 1 in diese eindiffundiert, bis eine durchgehende p-dotierte Zone 10 erzeugt ist. Bei der Trenndiffusion stellen die Tröpfchenbildung und das Zerfliessen der Struktur üblicherweise die grössten Probleme dar.

In den Fig. 14—18 ist als weitere Anwendungsmöglichkeit die Erzeugung einer inneren Konturierung, d.h. einer tiefen p-Diffusion mit örtlich abhängiger Eindringtiefe dargestellt.

Weitere Anwendungsmöglichkeiten können alle Prozesse sein, bei welchen das gleichmässige Schmelzen des Siliziums mit dem Aluminium von Bedeutung ist, was z.B. bei der Migration der Fall ist.

**Patentansprüche**

1. Verfahren zur Herstellung einer Halbleiteranordnung, wobei
a) auf wenigstens eine Hauptfläche (2) eines Siliziumsubstrats (1) Aluminium (7) abgeschieden,
b) dieses Aluminium (7) gemäss einem vorgebbaren Muster örtlich zu Aluminiumquellen (7, 11) strukturiert und
c) das mit einem Aluminiummuster beschichtete Siliziumsubstrat in einer Sauerstoff enthaltenden Atmosphäre auf eine Diffusionstemperatur erhitzt wird, bei der Aluminium aus den Aluminiumquellen (7, 11) in das Siliziumsubstrat (1) eindiffundiert und mindestens eine aluminiumdotierte Zone (10) in dem Siliziumsubstrat gebildet wird, dadurch gekennzeichnet, dass
d) nach dem Erhitzen auf die Diffusionstemperatur die auf der Hauptfläche (2) verbleibenden Reste der Aluminiumquellen (7, 11) durch Unterätzen mittels eines Silizium-Aetzmittels von ihrer Unterlage abgelöst werden.

2. Verfahren nach Anspruch 1, dadurch gekennzeichnet, dass für jede aluminiumdotierte Zone (10) mehrere voneinander beabstandete Aluminiumquellen (11) strukturiert werden.

EP 0 216 954 B1

3. Verfahren nach Anspruch 1 oder 2, dadurch gekennzeichnet, dass als Silizium-Aetzmittel eine isotrop wirkende Flüssigkeit, insbesondere ein Aetzmittel der Zusammensetzung

23 Vol-% HF
47 Vol-% $HNO_3$
20 Vol-% $CH_3COOH$
10 Vol-% $H_3PO_4$,

oder Schwefelhexafluorid $SF_6$ verwendet wird.

4. Verfahren nach einem der Ansprüche 1 bis 3, dadurch gekennzeichnet, dass

a) vor dem Entfernen der Reste der Aluminiumquellen (11) ein Photolack (13) auf die nichtdiffundierten Gebiete der Hauptfläche (2) des Siliziumsubstrats (1) und

b) ganzflächig auf dessen Rückseite (14) aufgebracht wird.

5. Verfahren nach Anspruch 1, dadurch gekennzeichnet, dass das Aluminium durch Kathodenzerstäubung in einem nicht korrodierenden Gasplasma auf dem Siliziumsubstrat (1) abgeschieden wird.

6. Verfahren nach Anspruch 5, dadurch gekennzeichnet, dass
das Zerstäuben in einem Edelgasplasma,
insbesondere in einem Argon-Plasma, durchgeführt wird.

7. Verfahren nach Anspruch 5 oder 6, dadurch gekennzeichnet, dass
das Siliziumsubstrat (1) vor der Aluminium-Abscheidung mit Edelgas-Ionen,
insbesondere durch Argon-Ionen, bombardiert wird.

8. Verfahren nach einem der Ansprüche 5 bis 7, dadurch gekennzeichnet, dass
auf mindestens einer Hauptfläche (2) des mit einem Aluminiummuster beschichteten Siliziumsubstrats (1) vor dem Erhitzen auf die Diffusionstemperatur eine Diffusions-Schutzschicht aufgebracht wird, insbesondere dass eine $SiO_2$-Diffusions-Schutzschicht aufgebracht wird.

9. Verfahren nach einem der Ansprüche 5 bis 8, dadurch gekennzeichnet, dass

a) das Erhitzen des Siliziumsubstrats (1) von ca. 500°C auf eine Diffusionstemperatur von etwa 1250°C mit einer Aufheizgeschwindigkeit von etwa 3 K/min durchgeführt wird, dass

b) das Siliziumsubstrat etwa 300 min auf dieser Diffusionstemperatur gehalten wird und dass

c) anschliessend mit einer Abkühlgeschwindigkeit von etwa 1 K/min auf 500°C abgekühlt wird.

10. Halbleiteranordnung mit

a) einem Siliziumsubstrat (1),

b) das mindestens eine aluminiumdotierte Zone (10) aufweist, dadurch gekennzeichnet, dass

c) die Oberfläche mindestens einer aluminiumdotierten Zone mehrere, im wesentlichen pyramiden- oder kegelförmige Erhöhungen (12) aufweist, welche Erhöhungen nicht über das Niveau der nichtdiffundierten Gebiete der Hauptfläche (2) des Siliziumsubstrats (1) herausragen.

**Revendications**

1. Procédé de fabrication d'un dispositif semiconducteur, suivant lequel:

a) de l'aluminium (7) est déposé sur au moins une face principale (2) d'un substrat de silicium (1);

b) cet aluminium (7) est structuré localement en sources d'aluminium (7, 11) suivant un motif qui peut être imposé, et

c) le substrat de silicium revêtu du motif d'aluminium est chauffé dans une atmosphère contenant de l'oxygène jusqu'à une température de diffusion à laquelle l'aluminium pénètre par diffusion à partir des sources d'aluminium (7, 11) dans le substrat de silicium (1) et au moins une zone dopée à l'aluminium (10) est formée dans le substrat de silicium, caractérisé en ce que:

d) après le chauffage jusqu'à la température de diffusion, les résidus des sources d'aluminium (7, 11) subsistant sur la face principale (2) sont dégagés de leurs fonds par minage à l'aide d'un agent de décapage de silicium.

2. Procédé suivant la revendication 1, caractérisé en ce que plusieurs sources d'aluminium (11) espacées les unes des autres sont structurées pour chaque zone dopée à l'aluminium (10).

3. Procédé suivant la revendication 1 ou 2, caractérisé en ce qu'un liquide à action isotrope, en particulier un agent de décapage de la composition:

23% en volume HF
47% en volume $NHO_3$
20% en volume $CH_3COOH$
10% en volume $H_3PO_4$

ou de l'hexafluorure de soufre $SF_6$ est utilisé comme agent de décapage du silicium.

4. Procédé suivant l'une quelconque des revendications 1 à 3, caractérisé en ce que:

a) avant l'élimination des résidus des sources d'aluminium (11), une laque photosensible (13) est appliquée sur les régions non diffusées de la surface principale (2) du substrat de silicium (1), et

b) sur le revers (14) de celui-ci dans toute l'étendue de la surface.

7

5. Procédé suivant la revendication 1, caractérisé en ce que l'aluminium est déposé par pulvérisation cathodique dans un plasma de gaz non corrosif sur le substrat de silicium (1).

6. Procédé suivant la revendication 5, caractérisé en ce que la pulvérisation est exécutée dans un plasma de gaz noble, en particulier, un plasma d'argon.

7. Procédé suivant la revendication 5 ou 6, caractérisé en ce que le substrat de silicium (1) est bombardé avant le dépôt de l'aluminium à l'aide d'ions d'un gaz noble, en particulier d'ions argon.

8. Procédé suivant l'une quelconque des revendications 5 à 7, caractérisé en ce qu'une couche antidiffusion, en particulier une couche antidiffusion en $SiO_2$ est appliquée sur au moins une face principale (2) du substrat de silicium (1) revêtu du motif d'aluminium, avant le chauffage jusqu'à la température de diffusion.

9. Procédé suivant l'une quelconque des revendications 5 à 8, caractérisé en ce que:

a) le chauffage du substrat de silicium (1) depuis environ 500°C jusqu'à une température de diffusion d'environ 1250°C est exécuté avec une vitesse de chauffage d'environ 3 K par minute, que

b) le substrat de silicium est maintenu pendant environ 300 minutes à cette température de diffusion, et que

c) un refroidissement jusqu'à 500°C est ensuite effectué à une vitesse de refroidissement d'environ 1 K par minute.

10. Dispositif semi-conducteur comprenant:

a) un substrat de silicium (1);

b) qui comprend au moins une zone dopée à l'aluminium (10), caractérisé en ce que:

c) la surface d'au moins une zone dopée à l'aluminium présente plusieurs protubérances (12) sensiblement en forme de pyramides ou de cônes, lesquelles protubérances ne font pas saillie au-dessus du niveau des régions non diffusées de la face principale (2) du substrat de silicium (1).

## Claims

1. Method for producing a semiconductor arrangement, in which

a) on at least one major face (2) of a silicon substrate (1) aluminium (7) is deposited,

b) this aluminium (7) is locally structured to form aluminium sources (7, 11) in accordance with a predetermined pattern and,

c) the silicon substrate coated with an aluminium pattern is heated to a diffusion temperature in an oxygen-containing atmosphere, in which method aluminium from the aluminium sources (7, 11) is diffused into the silicon substrate (1) and at least one aluminium-doped zone (10) is formed in the silicon substrate, characterized in that

d) after the heating to the diffusion temperature, the residues of the aluminium sources (7, 11) remaining on the major face (2) are separated from their support by lateral etching by means of a silicon etchant.

2. Method according to Claim 1, characterized in that several aluminium sources (11) spaced apart from each other are structured for each aluminium-doped zone (10).

3. Method according to Claim 1 or 2, characterized in that as silicon etchant, a liquid with isotropic effect, particularly an etchant having the composition

23% by volume HF
47% by volume $HNO_3$
20% by volume $CH_3COOH$
10% by volume $H_3PO_4$

or sulphur hexafluoride $SF_6$ is used.

4. Method according to one of Claims 1 to 3, characterized in that

a) before removal of the residues of the aluminium sources (11), a photoresist (13) is applied to the non-diffused regions of the major face (2) of the silicon substrate (1) and

b) over the whole area of its reverse side (14).

5. Method according to Claim 1, characterized in that the aluminium is deposited on the silicon substrate (1) by cathode sputtering in a non-corroding gas plasma.

6. Method according to Claim 5 characterized in that the sputtering is carried out in a rare-gas plasma, particularly in an argon plasma.

7. Method according to Claim 5 or 6, characterized in that the silicon substrate (1) is bombarded with rare-gas ions before the aluminium deposition, particularly with argon ions.

8. Method according to one of Claims 5 to 7, characterized in that on at least one major face (2) of the silicon substrate (1) coated with an aluminium pattern, a diffusion protection layer is applied preceding the heating to the diffusion temperature, particularly that an $SiO_2$ diffusion protection layer is applied.

9. Method according to one of Claims 5 to 8, characterized in that

a) the heating of the silicon substrate (1) from about 500°C to a diffusion temperature of about 1250°C is carried out at a rate of heating of about 3 K/min, that

b) the silicon substrate is maintained at this diffusion temperature for about 300 min, and that

c) subsequently cooling is carried out at a rate of cooling of about 1 K/min to about 500°C.

10. Semiconductor arrangement comprising

a) a silicon substrate (1),

b) which has at least one aluminium-doped zone (10), characterized in that

c) the surface of at least one aluminium-doped zone has several essentially pyramid- or cone-shaped raised parts (12), which raised parts do not project past the level of the non-diffused regions of the major face (2) of the silicon substrate (1).

EP 0 216 954 B1

FIG. 1

FIG. 2

FIG. 3

FIG. 4

FIG. 5

FIG. 6

1

FIG.7

FIG.8

FIG.9

FIG.10

FIG.11

FIG.13

EP 0 216 954 B1

FIG. 12

FIG. 14

FIG. 15

FIG. 16

FIG. 17

FIG. 18

3